# EUROPEAN PATENT APPLICATION

(11) **EP 4 566 788 A1**
(43) Date of publication of application: **11.06.2025**
(21) Application number: 23776095.4
(22) Date of filing: 01.08.2023
(51) Int. Cl.: B29C 39/10, B29C 39/42, B29C 39/24, B29C 39/38, B29C 33/44, B29C 33/02, H01L 33/54

(54) **METHOD, DEVICE AND COMPONENTS FOR MANUFACTURING EMBEDDED OPTICS FOR PHOTONIC COMPONENTS**

(30) Priority: 03.08.2022 ES 202230720
(71) Applicant: QUALITY PHOTONIC OPTICS S.L., 08221 Terrassa Barcelona (ES)
(72) Inventor: PIZARRO BONDIA, Carlos, 08221 Terrassa Barcelona (ES); ALVAREZ DOMINGUEZ, Noemi, 08221 Terrassa Barcelona (ES); ARASA MARTIN, Jose, 08221 Terrassa Barcelona (ES); BLANCO NIETO, Patricia, 08221 Terrassa Barcelona (ES)
(74) Representative: Curell Suñol S.L.P.
(86) International application number: PCT/IB2023/000458
(87) International publication number: WO 2024/028651

(57) **Abstract**

The invention of the method for manufacturing an embedded optics in photonic components relates to a method for manufacturing an embedded optics that uses thermoplastic material to generate these optics, a thermostatted system for manufacturing the same, an open thermostatted containment structure or cavity, an autonomous thermoplastic material dispensing unit, a controlled temperature and atmosphere gas unit, and a cooling unit. The invention also relates to a system for manufacturing an embedded optics with a continuous thermal process.

## Description

### Field of the Invention

The invention relates to a method for manufacturing an embedded optics that uses thermoplastic material to generate these optics, a thermostatted system for manufacturing same, an open thermostatted containment structure or cavity, an autonomous thermoplastic material dispensing unit, a controlled temperature and atmosphere gas unit, preferably airtight, and a cooling unit. The invention also relates to a system for manufacturing an embedded optics with a continuous thermal process.

More specifically, the invention relates to a method for manufacturing an embedded optics for photonic components, the photonic components being suitable for emitting or capturing an electromagnetic radiation of a given frequency, with the optics being made of a thermoplastic material with a melting temperature Tₘ, the thermoplastic material being suitable for transmitting the electromagnetic radiation, and the photonic component being on a physical carrier. The invention also relates to a containment structure, an autonomous thermoplastic material dispensing unit, and to a device for manufacturing an embedded optics for photonic components, these photonic components being suitable for emitting or capturing an electromagnetic radiation of a given frequency, with the optics being made of a thermoplastic material with a melting temperature Tₘ, the thermoplastic material being suitable for transmitting the electromagnetic radiation, and the photonic component being on a physical carrier.

### State of the Art

The concept of Wafer-Level Optics, as defined by EV Group, https://www.evgroup.com/technologies/wafer-level-optics/, allows the design and manufacture of miniaturized wafer-level optics using advanced techniques similar to those of semiconductors, with the end product being a miniaturized optics. There is a wide range of manufacturing techniques that allow developing these optics, most of said techniques being based on lithography and on lens molding.

There is also Wafer Level Packaging (WLP), https://ams.com/advanced-packaging. As defined by AMS-OSRAM AG, this is a process in which the components of the photonic component are connected to an integrated circuit (IC) before the wafer, in which the IC is manufactured, is cut into cubes. In WLP, the upper and lower layers of the packaging and the welding protrusions are attached to the integrated circuits as long as they are in the wafer. This process differs from a more conventional process, in which the wafer is cut into individual circuits (dies) before attaching the packaging components.

Wafer Level Chip Scale Packaging (WL-CSP) is the smallest packaging currently available on the market and is produced by the company OSAT (Outsourced Semiconductor Assembly and Test).

In addition to these wafer level concepts, there is also Optical Packaging, having various definitions and different types, as defined by Tolga Tekin et al. in Review of Packaging of Optoelectronic, Photonic, and MEMS Components, Tolga Tekin, July 2011, Review of Packaging of Optoelectronic, Photonic, and MEMS Components, IEEE Journal of Selected Topics in Quantum Electronics 17(3):704 - 719, DOI: 10.1109/JSTQE.2011.2113171. Among them are included those ranging from the elements external used as protection for the optical elements of a system, such as a box or envelope, to the outer "enclosure" of a set of optical/electronic/mechanical elements, the function of which is to protect same.

It can be seen that there are packagings which are only used to hold, connect, or protect the parts of the photonic component, but there are also those which have the optics built in in order to confer optics functionality to the emitter, in the same packaging, such as in the overmolded die on lead frame, which can be found in Tolga Tekin *et al.*

The concept of an embedded optics can be defined in several ways. It can be assumed that an embedded lens is one that is manufactured directly on the element to which optical functionality is to be conferred, and also lenses that are embedded in the packaging of the components. The embedded optics can be manufactured by means of injection molding, CNC machining, 3D printing, and even as previously seen, by means of lithography.

Currently, among those manufacturing processes in which materials that need to be heated and melted are used, on one hand, the injection manufacturing process stands out. In this manufacturing process, the pressure with which the material reaches the closed cavity, usually presents problems at the level of filling the closed cavity, since this gradient causes the material not to arrive with the optimal temperature to fill the entire closed cavity in a fluid manner, leaving hard-to-reach areas unfilled. Furthermore, the material is heated and melted, to then be sent to the closed cavity, by means of a certain pressure, in order to fill same and to be able to adopt the designed shape by means of the cooling thereof. In this process, the material experiences a thermal gradient from its dispensing until filling the closed cavity, as described in the following mentioned patents.

Patent WO2008100146A2 relates to a method for encapsulating electronic components mounted on a carrier using under-pressure, comprising the processing steps of: A) placing an electronic component in a mould cavity, B) heating encapsulating material, C) displacing the encapsulating material to the mould cavity, D) filling the mould cavity, and E) cooling the encapsulating material in the mould cavity. The invention also relates to a device with which such a method can be performed.

Patent WO2005120799A1 relates to a method for encapsulating electronic components mounted on a carrier, comprising the processing steps of: A) heating encapsulating material, B) displacing the encapsulating material to a mould cavity, C) filling the mould cavity, and D) cooling the encapsulating material in the mould cavity. Whereby the temperature regulation of the encapsulating material takes place during separate sections of the path covered by the encapsulating material by creating different temperature zones at least partially separated from each other thermally by means of at least one temperature barrier. The invention also relates to a device for encapsulating electronic components mounted on a carrier.

Patent WO2010008287A1 relates to a method for encapsulating electronic components mounted on a carrier, comprising the processing steps of: moving a number of mould parts toward each other with a closing force whereby the electronic component is enclosed by a mould cavity, exerting pressure on a liquid encapsulating material, filling the mould cavity with encapsulating material, and curing the encapsulating material, wherein the pressure on the encapsulating material is measured, and the closing force of the mould parts and the exerted pressure are dependent on each other.

Patent US20200147865A1 relates to a dispenser attachment for microscope objective lenses, in a device for writing three-dimensional structures by means of laser lithography in a lithographic fluid, which can be solidified by irradiation with laser light.

On the other hand, additive manufacturing, also known as 3D printing, also stands out, in which the material needs to be heated and melted in the manufacturing process to be able to confer to it the desired shape, and this material is in direct contact with the air at the time of its dispensing, so from the moment in which it is dispensed by means of the dispensing system, the material experiences a very high temperature gradient, which leads to rough and low-precision finishes in the manufactured components, and they usually require post-process to minimize such imperfections. The following mentioned patents show this thermal gradient the material experiences from the moment in which it is dispensed.

Patent WO2013017284A2 relates to a method and a device for producing a three-dimensional object made of a material that can be solidified and that in the initial state is either present as a liquid or can be liquefied. The three-dimensional object is produced into the discharged material to be solidified simultaneously with discharging the material that can be solidified.

Patent US20140197576A1 relates to a device and the method that serve for producing a three-dimensional object from a solidifiable by a sequential discharge of drops onto an object carrier for the object to be produced.

Patent US9539765 relates to a method for discharging a volume flow consisting of successive drops to produce a three-dimensional object of solidifiable material present in a fluid phase to which a pressure is applied in order to discharge the material in drops out of a cyclable outlet opening to build up the three-dimensional object in a construction chamber.

Patent US9889604B2 relates to a device for producing a three-dimensional object from hardenable material that has a construction space for constructing the object, a temperature control unit for controlling the temperature of the construction space, and a preparation unit for preparing the hardenable material in such a way that the material is in the fluid phase. A pressure generation unit applies pressure to the fluid phase in the preparation unit for discharging the hardenable material through an outlet in the form of drops. The temperature-controlled construction space is surrounded by a construction space frame in which at least the discharge unit, the preparation unit, and the object support for producing the object are housed.

In general, photonic components (for example, LEDs) are mounted on a carrier (usually a printed circuit board (PCB)) such that the electrical connection between the photonic component and the carrier is carried out through connectors forming an arc. In the methods using plastic injection techniques, it is not uncommon for this arc to break.

### Disclosure of the Invention

The object of the invention is to overcome these drawbacks. This is achieved by means of a method for manufacturing an embedded optics for photonic components of the type indicated above characterized in that it is used a containment structure comprising a thermostatted cavity, suitable for being filled with the thermoplastic material, where the thermostatted cavity is open, and a support structure, suitable for supporting the physical carrier on the cavity such that the photonic component is inside the cavity, where when the physical carrier is supported by the support structure, the thermostatted cavity is partially open, where the method comprises the following steps:
[a] melting the thermoplastic material,
[b] positioning the physical carrier with the photonic component on the support structure, such that the photonic component is inside the thermostatted cavity and the thermostatted cavity being partially open,
[c] filling the thermostatted cavity with the molten thermoplastic material in a filling unit, where the thermostatted cavity is kept at a temperature T_{c} greater than Tₘ during the step of filling the thermostatted cavity by means of a temperature control system,
[d] once the thermostatted cavity is filled, cooling the thermostatted cavity below the Tₘ,
[e] ejecting the photonic component, coated with the thermoplastic material, from the thermostatted cavity by means of ejectors.

In general, methods using the 3D printing technique do not use any type of cavity. In turn, methods for injecting polymer materials use a closed cavity. It should be well understood what it means to say that the cavity is closed: it is closed in the sense that the molten thermoplastic material cannot exit the cavity. However, the cavity is not airtight, given that it has holes that allow air to exit, i.e., the cavity "is not closed to air but it is closed to the thermoplastic material". In the present description and claims, the expressions "closed cavity" and "cavity open" have been used in this sense, i.e., the cavity is closed or open with respect to the molten thermoplastic material.

Indeed, it has been seen that the arc of the contact electrically binding the photonic component with the physical carrier is structurally very weak and prone to breaking if subjected to mechanical stresses. The method according to the invention allows the generation of the optics without subjecting the connectors to virtually any mechanical stress at all, and, even still, having a surface (the inner face of the thermostatted cavity) that can serve to generate optically functional surfaces. Since the cavity is open and is at a temperature T_{c} above the melting temperature Tₘ, an extremely "smooth" filling of the cavity is guaranteed since the polymer material retains a state of fluidity and a viscosity as low as desired throughout the entire process of filling the cavity. The connectors are thereby not subjected to any negative stress.

Preferably the pressure in the cavity is ambient pressure.

Preferably the electromagnetic radiation is visible and/or infrared radiation.

Preferably the filling unit is a controlled temperature and atmosphere gas unit, where said gas is preferably an oxygen-free gas. Advantageously the gas is at a temperature T_{g} greater than the temperature of said thermostatted cavity.

Preferably, step [d] is performed in a cooling unit.

Preferably, step [a] of melting the thermoplastic material is performed in an autonomous material dispensing unit which advantageously has a temperature control system.

Preferably, the step [c] of filling said thermostatted cavity with said molten thermoplastic material is performed by gravity.

Preferably, the filling unit has an inlet area and an outlet area suitable for allowing the entry and exit, respectively, of the containment structure.

Preferably, the physical carrier comprises at least one hole and in the step [c] of filling the thermostatted cavity, the molten thermoplastic material exits the thermostatted cavity through the hole, forming a head suitable for retaining the optics on the physical carrier.

Preferably, said thermoplastic material is cyclic olefin polymer and in that said temperature T_{c} is comprised between 100°C and 420°C, preferably between 220°C and 260°C.

Preferably, said thermoplastic material is polycarbonate and in that said temperature T_{c} is comprised between 100°C and 420°C, preferably between 260°C and 310°C.

Preferably, said thermoplastic material is polymethylmethacrylate and in that said temperature T_{c} is comprised between 100°C and 420°C, preferably between 100°C and 180°C.

The object of the invention is a containment structure characterized in that it comprises: [a] a thermostatted cavity, suitable for being filled with a molten thermoplastic material, where the thermostatted cavity is open, [b] a support structure, suitable for supporting a physical carrier with a photonic component on the thermostatted cavity such that the photonic component is inside the thermostatted cavity, where when the physical carrier is supported by the support structure, the thermostatted cavity is partially open, and [c] a temperature control system suitable for keeping the thermostatted cavity at a temperature T_{c} greater than the melting temperature Tₘ of the thermoplastic material.

Preferably, the containment structure comprises ejectors suitable for ejecting the photonic component, coated with the thermoplastic material, from the thermostatted cavity.

Preferably, the containment structure comprises a plurality of thermostatted cavities.

The invention also has as an object an autonomous thermoplastic material dispensing unit, characterized in that it comprises a temperature control system suitable for melting the plastic material and keeping it at a temperature T_{d} greater than Tₘ and in that it dispenses the molten thermoplastic material by gravity.

Another object of the invention is a device for manufacturing an embedded optics for photonic components of the type indicated above, characterized in that it comprises a containment structure and a filling unit where the containment structure, in turn, comprises: [a] a thermostatted cavity, suitable for being filled with a molten thermoplastic material, where the thermostatted cavity is open, [b] a support structure, suitable for supporting a physical carrier with a photonic component on the cavity such that the photonic component is inside the cavity, where when the physical carrier is supported by the support structure, the thermostatted cavity is partially open, and [c] a temperature control system suitable for keeping the thermostatted cavity at a temperature T_{c} greater than the melting temperature Tₘ of the thermoplastic material.

This containment device may include various preferred solutions:
- Preferably, the containment structure comprises ejectors suitable for ejecting the photonic component, coated with the thermoplastic material, from the thermostatted cavity.
- Preferably, the containment structure comprises a plurality of thermostatted cavities.
- Preferably, it comprises an autonomous thermoplastic material dispensing unit which, in turn, comprises a temperature control system suitable for melting the plastic material and keeping it at a temperature T_{d} greater than Tₘ and dispenses the molten thermoplastic material by gravity.
- Preferably, the autonomous thermoplastic material dispensing unit comprises a reservoir suitable for containing an oxygen-free gas.
- Preferably, the filling unit is a controlled temperature and atmosphere gas unit, where, advantageously, the gas is an oxygen-free gas.
- Preferably, the controlled temperature and atmosphere gas unit has a temperature control system suitable for keeping the gas at a temperature T_{g} greater than the temperature of the thermostatted cavity.
- Preferably, the filling unit has an inlet area and an outlet area suitable for allowing the entry and exit, respectively, of the containment structure.
- Preferably, it comprises a cooling unit.
- Preferably, the outlet area is connected to an inlet of the cooling unit.
- Preferably, a heating plate that allows the temperature of said cavity to be adjusted.

In general, the device according to the invention is suitable for carrying out the method according to the invention.

Other preferred embodiments of the invention are the following:
1. A method for manufacturing an embedded optics for photonic components based on the use of a thermoplastic material for generating these optics in a continuous thermal process with
   - at least one controlled temperature and atmosphere gas unit, preferably airtight,
   - an open thermostatted containment structure or cavity,
   - an autonomous thermoplastic material dispensing unit,
   - and a cooling unit,
   - where the controlled temperature and atmosphere gas unit, preferably airtight, has a temperature control system and includes at least an open thermostatted containment structure or cavity, an autonomous thermoplastic material dispensing unit, and an inlet area and outlet area for the open thermostatted containment structure or cavity,
   - where the open thermostatted containment structure or cavity has at least one temperature control system,
   - where the autonomous thermoplastic material dispensing unit can process the solidifiable material in liquid or liquefiable phase in order to dispense same and has a temperature control system.
2. An open thermostatted containment structure or cavity according to paragraph 1, characterized in that it houses at least
   - an inlet system for the thermoplastic material,
   - a support and/or fixing structure to position at least the physical carrier where the optoelectronic components that are part of the photonic component are housed,
   - a temperature control system,
   - ejectors for being able to eject the final embedded photonic component from the open thermostatted containment structure or cavity,
   - a moving system or not, for moving from the controlled temperature and atmosphere gas unit, preferably airtight, to the cooling unit,
   - an optics.
3. An open thermostatted containment structure or cavity according to paragraph 2, characterized in that it houses at least several cavities in the form of an array which will form the optics to be embedded.
4. An autonomous thermoplastic material dispensing unit according to paragraph 1, characterized in that fills the open thermostatted containment structure or cavity with fluid thermoplastic material by means of the effect of gravity.
5. A controlled temperature and atmosphere gas unit, preferably airtight, according to paragraph 1, characterized in that it uses oxygen-free gases to prevent ignition.
6. A controlled temperature and atmosphere gas unit, preferably airtight, according to paragraph 1, characterized in that it allows the dispensing of the fluid thermoplastic material without subjecting it to a temperature gradient.
7. A controlled temperature and atmosphere gas unit, preferably airtight, according to paragraph 1, characterized in that its temperature is greater than the temperature of the open thermostatted containment structure or cavity.
8. A cooling unit according to paragraph 1, characterized in that it can house at least the open thermostatted containment structure or cavity filled with the thermoplastic.
9. A cooling unit according to paragraph 1, characterized in that it carries out the process of cooling the material, subjecting it to a thermal gradient together with the open thermostatted containment structure or cavity.
10. A cooling unit according to paragraph 1, characterized in that its temperature is less than the temperature of the controlled temperature and atmosphere gas unit, preferably airtight.

### Brief Description of the Drawings

To complement the description that is being made and for the purpose of helping to better understand the features of the invention, a set of figures is attached as an integral part of said description in which the following is depicted in an illustrative and non-limiting manner:

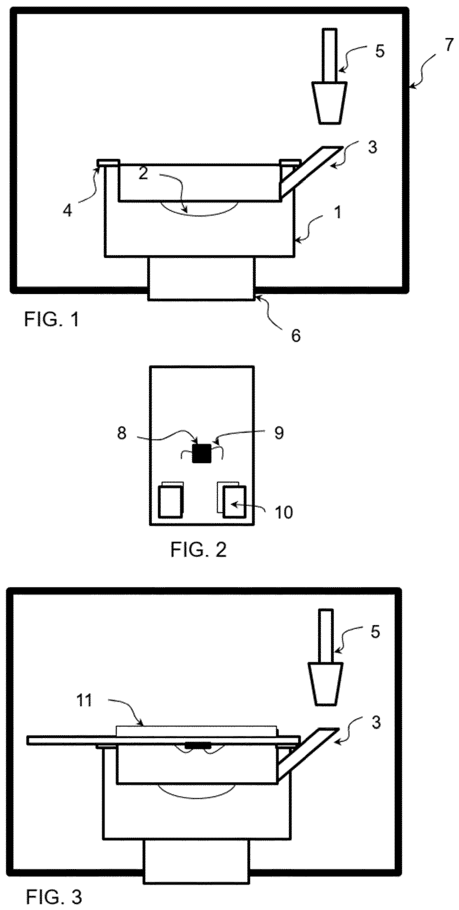

Figure 1 shows a schematic depiction of the system for manufacturing an embedded optics with the open thermostatted cavity for a single optics, the autonomous material dispensing unit, the displacing system and the controlled atmosphere gas unit, preferably airtight, according to the invention.
Figure 2 shows a schematic depiction of a photonic component made up of a physical carrier where there is installed the emitter with the control electronics, the connections, and the communication channels for the thermoplastic material to flow through the component.
Figure 3 shows a schematic depiction of the system for manufacturing an embedded optics with the thermostatted cavity for a single optics filled with thermoplastic.

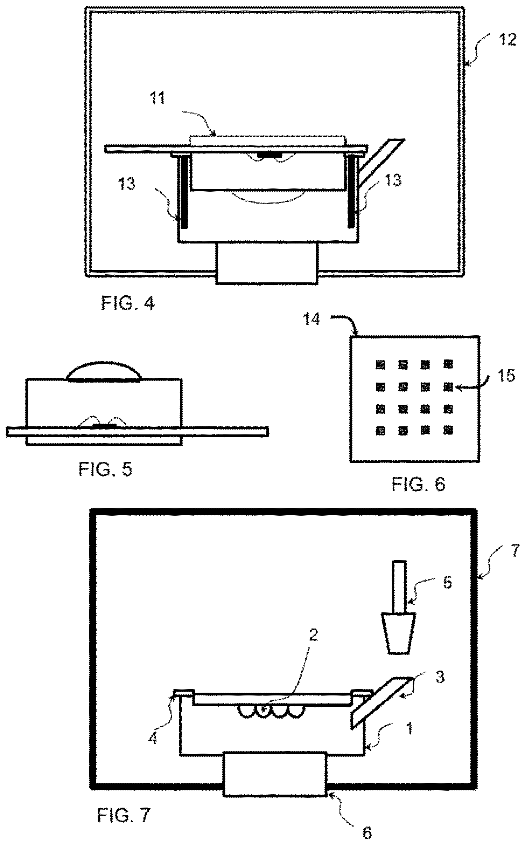

Figure 4 shows a schematic depiction of the thermostatted cavity for a single optics filled with thermoplastic, in the cooling unit.
Figure 5 shows a schematic depiction of the photonic component with a single optics, manufactured according to the invention.
Figure 6 shows a schematic depiction of a photonic component made up of an array of emitters.
Figure 7 shows a schematic depiction of the system for manufacturing an embedded optics with the thermostatted cavity for an array of optics, according to the invention.

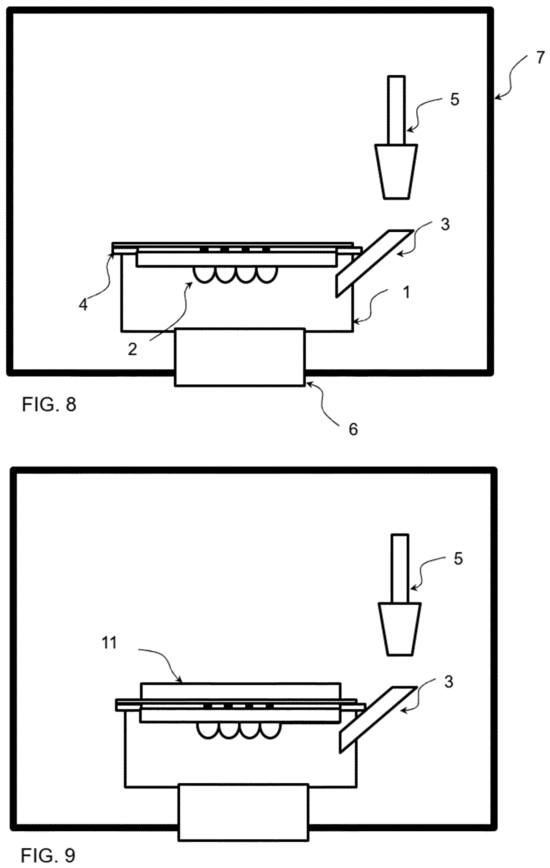

Figure 8 shows a schematic depiction of the system for manufacturing an embedded optics for an array of optics, with the photonic component to be embedded, according to the invention.
Figure 9 shows a schematic depiction of the system for manufacturing an embedded optics for an array of optics, with the cavity full of thermoplastic.

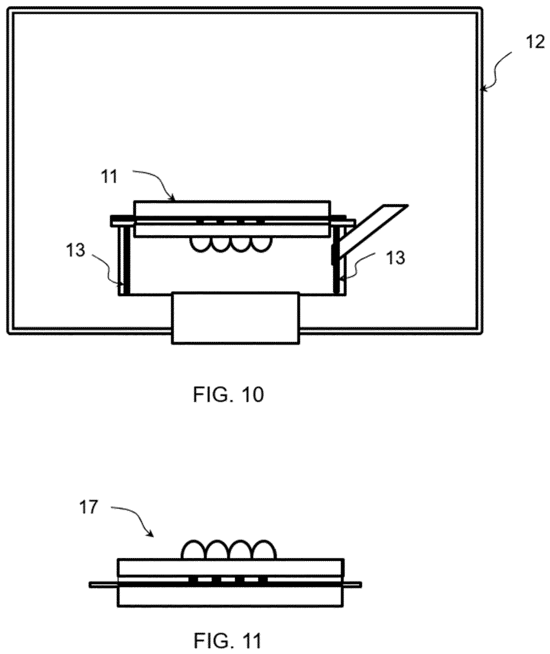

Figure 10 shows a schematic depiction of the system for manufacturing an embedded optics for an array of optics, with the cavity full of thermoplastic, in the cooling unit, according to the invention.
Figure 11 shows a schematic depiction of the embedded photonic component with an array of optics, manufactured according to the invention.

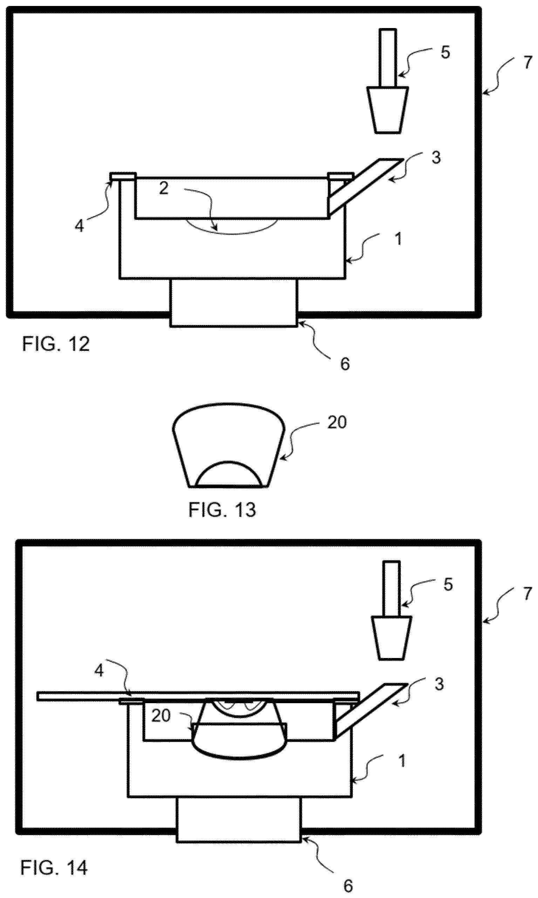

Figure 12 shows a schematic depiction of one of the embodiments of the invention, of the system for manufacturing an embedded optics with the thermostatted cavity for a single previously manufactured optics, with the autonomous material dispensing unit, the displacing system, and the controlled atmosphere gas unit, preferably airtight, according to the invention.
Figure 13 shows a schematic depiction of a previously manufactured optics.
Figure 14 shows a schematic depiction of the system for manufacturing an embedded optics with the previously manufactured optics in the thermostatted cavity, according to the invention.

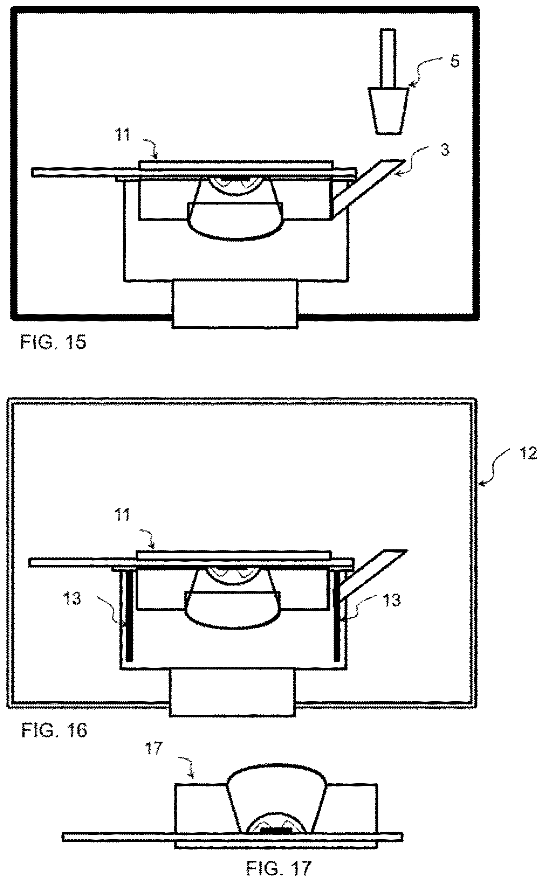

Figure 15 shows a schematic depiction of the system for manufacturing an embedded optics with the previously manufactured optics in the thermostatted cavity full of thermoplastic.
Figure 16 shows a schematic depiction of the system for manufacturing an embedded optics with the previously manufactured optics in the thermostatted cavity full of thermoplastic, in the cooling unit.
Figure 17 shows a schematic depiction of the photonic component embedded with a previously manufactured optics, manufactured according to the invention.
Figure 18 shows a schematic depiction of another system for manufacturing an embedded optics with a temperature control and monitoring system, a heating plate, and a displacing system of an autonomous plastic dispensing unit.

### Detailed Description of Embodiments of the Invention

The invention describes a method for manufacturing an embedded optics for photonic components, where photonic component is understood to mean any system made up of a physical carrier wherein electronic and electric components are installed and interconnected with one another, an emitter or a detector, and the optics needed to confer optical functionality to this component. This embedded optics is not limited to being a single optics, since the manufacture of an array of optics, as well as the embedding of optics previously manufactured as an individual optics or in the form of an array, are also contemplated.

The method for manufacturing an embedded optics for photonic components uses thermoplastic material for generating these optics, a thermostatted system for manufacturing same, an open thermostatted containment structure or cavity, an autonomous thermoplastic material dispensing unit, a controlled temperature and atmosphere gas unit, preferably airtight, and a cooling unit.

Our system for manufacturing an embedded optics for photonic components according to the invention has a primary advantage given that the material does not experience any temperature gradient between its melting and the filling of the cavity, and consists of a continuous thermal process from the time it is heated and melted until it is dispensed and the open thermostatted cavity is filled, such that the fluid state of the material is maintained in the most optimal manner. This open thermostatted cavity is located inside a controlled temperature and atmosphere gas unit, preferably airtight, which allows maintaining the temperature of the open thermostatted cavity and the temperature of the environment in a controlled manner. Unlike current processes, in the process according to the invention, the material is subjected to the thermal gradient for cooling, together with the open thermostatted cavity, in the moment in which this cavity is in the cooling unit and not at the time of being dispensed.

Another advantage present in the system for manufacturing an embedded optics for photonic components according to the invention is that the dispensing of the material is performed by means of a material dispensing unit, which allows the material to fall into the system for filling the open thermostatted cavity due to the effect of gravity, so external pressure is not required to that end. The state of the electrical, electronic, and optical components that are part of the photonic component is thereby protected given that it is assured that the entry of material in the open thermostatted cavity will not damage these components due to pressure.

Furthermore, in the process for manufacturing an embedded optics for photonic components according to the invention, the cooling process is performed in a cooling unit which the open thermostatted cavity with the material to be cooled reaches in order to obtain the embedded optics for the photonic component in question by means of a displacing system, such that the open thermostatted cavity with the material experiences the thermal gradient directly, and not the material. This cooling unit can be immediately below, above, to the side, or even separated from the controlled atmosphere gas unit, so it is not limited in the location thereof.

In view of the mentioned figures and according to the numbering adopted, it is possible to see therein a preferred embodiment of the invention which comprises the parts and elements indicated and described in detail below.

In that sense, in one of the embodiments of the invention, the system for manufacturing an embedded optics consists of an open thermostatted containment structure or cavity (1) provided with a temperature control system, containing the negative (2) of the embedded optics to be manufactured, an inlet system (3) for the thermoplastic material, a support and/or fixing structure (4) to position the physical carrier where the optoelectronic components that are part of the photonic component are housed, if there are any, and an autonomous thermoplastic material dispensing unit (5). The containment structure may or may not be positioned on a displacing system (6) which will allow displacement of the containment structure in directions X, Y, and Z. In turn, the thermostatted containment structure (1) as the inlet system (3) for the material and the autonomous thermoplastic material dispensing unit (5) are located in a controlled atmosphere gas unit (7), preferably airtight, which allows the atmosphere at which the material is dispensed to be at a specific and controlled temperature. This controlled atmosphere gas unit (7), has an opening which will allow the entry or exit of the thermostatted containment structure, and it will preferably be closed at all times in an airtight manner.

This containment structure is thermostatted to the temperature suitable for the thermoplastic material used for generating the optics embedded to be able to fill the cavity without experiencing alterations in its fluidity or modifying its chemical properties.

In a particular case of the invention, the optoelectronic components of the photonic component consist of a physical carrier where the emitter with the control electronics (8), the connection cables (9) and the communication channels (10) for the thermoplastic material to flow through the component (10) are located.

The method for manufacturing an embedded optics for photonic components in a particular case of the invention starts with the placement of the optoelectronic components of the photonic component in the support and/or fixing structure (4) of the thermostatted containment structure (1), which are located in the controlled atmosphere gas unit (7), preferably airtight.

By means of the autonomous thermoplastic material dispensing unit (5), the cavity (2) is filled with thermoplastic material by means of the inlet system (3) for the thermoplastic material, the cavity of the embedded optics (11) thus being full.

The next step in the method for manufacturing an embedded optics for photonic components consists of cooling/solidifying the thermoplastic material inside the cavity (2). To that end, the thermostatted containment structure (1) will be displaced from the controlled atmosphere gas unit (7), by means of the outlet and the displacing elements, to a cooling unit (12) to solidify the thermoplastics in the cavity and thus obtain the manufactured photonic component with the embedded optics.

In a particular case of the invention, the photonic component consists of an array of optoelectronic components (15) arranged on a physical carrier (14).

In this particular case of the invention, the thermostatted containment structure (1) provided with a temperature control system will be made up of several cavities (2) which will form the optics to be embedded, which may or may not be positioned, on a displacing system (6) which will allow displacement of the cavity in directions X, Y, and Z. In turn, the thermostatted containment structure (1) as the inlet system (3) for the material and the autonomous thermoplastic material dispensing unit (5) are located in a controlled atmosphere gas unit (7), preferably airtight, which allows the atmosphere at which the material is dispensed to be at a specific and controlled temperature. This controlled atmosphere gas unit has an opening which will allow the entry or exit of the thermostatted containment structure, and it will be kept closed at all times in a preferably airtight manner.

The method for manufacturing an embedded optics for photonic components in a particular case of the invention starts with the placement of the optoelectronic components of the photonic component in the support and/or fixing structure (4) of the thermostatted containment structure (1), which are located in the controlled atmosphere gas unit (7), preferably airtight.

By means of the autonomous thermoplastic material dispensing unit (5), the cavity is filled with thermoplastic material by means of the inlet system (3) for the thermoplastic material, the cavity of the embedded optics (11) thus being full.

The next step in the method for manufacturing an embedded optics for photonic components for this particular case of the invention consists of cooling/solidifying the thermoplastic material inside the thermostatted containment structure. To that end, the thermostatted containment structure will be displaced from the controlled atmosphere gas unit, by means of the outlet and the displacing elements, to a cooling unit (12) to solidify the thermoplastics in the cavity and thus obtain the photonic component with the embedded optics, which can be immediately below, above, to the side, or even separated from the controlled atmosphere gas unit.

Once the thermoplastic material has solidified, the final embedded photonic component (17) is ejected by means of the ejectors with which the thermostatted containment structure is provided.

In a particular case of the invention, the photonic component consists of a single optoelectronic component or array of optoelectronic components, which may or may not contain an emitter with the control electronics, the connection cables, and the communication channels for the thermoplastic material to flow through the component arranged on a physical carrier.

In this particular case of the invention, the thermostatted containment structure provided with a temperature control system will be made up of one or more cavities (2) for the positioning of a previously manufactured optics (20), by means of any method of manufacture without limitation, such as CNC machining, 3D printing, injection, which may or may not be positioned on a displacing system (6) which will allow displacement of the cavity in directions X, Y, and Z. In turn, the thermostatted containment structure as the inlet system for the material and the autonomous thermoplastic material dispensing unit are located in a controlled atmosphere gas unit (7), preferably airtight, which allows the atmosphere at which the material is dispensed to be at a specific and controlled temperature. This controlled atmosphere gas unit has an opening which will allow the entry or exit of the thermostatted containment structure, and it will be kept closed at all times in a preferably airtight manner.

The method for manufacturing an embedded optics for photonic components in a particular case of the invention starts with the placement of the optoelectronic components of the photonic component in the support and/or fixing structure (4) and of the previously manufactured optics (20) in the thermostatted containment structure (1), which are located in the controlled atmosphere gas unit (7), preferably airtight.

By means of the autonomous thermoplastic material dispensing unit (5) the cavity for containing the thermoplastic material is filled by means of the inlet system (3) for the thermoplastic material, the cavity (11) thus being full, embedding the previously manufactured optics.

The next step in the method for manufacturing an embedded optics for photonic components consists of cooling/solidifying the thermoplastic material inside the cavity (2). To that end, the thermostatted containment structure will be displaced from the controlled atmosphere gas unit, by means of the outlet and the displacing elements, to a cooling unit (12) to solidify the thermoplastics in the cavity and thus obtain the photonic component with the embedded optics, which can be immediately below, above, to the side, or even separated from the controlled atmosphere gas unit.

Once the thermoplastic material has solidified, the final embedded photonic component (17) is ejected by means of the ejectors (13) with which the thermostatted containment structure is provided.

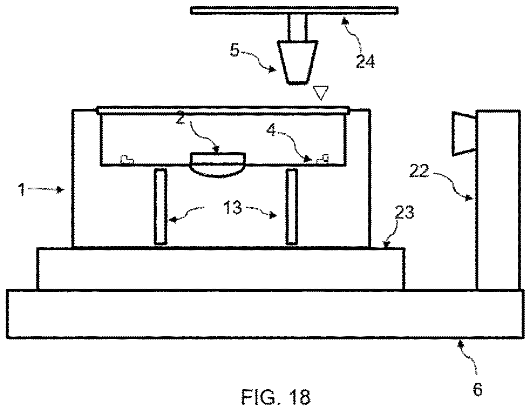

In a particular case of the invention depicted in Figure 18, the system for manufacturing an embedded optics for photonic components comprises a temperature control and monitoring system (22) which allows knowing the complete temperatures mapping of both the cavity and of the thermoplastic deposited in the cavity itself by means of infrared light, a heating plate (23) which allows adjusting the temperature of the cavity according to the needs of the thermoplastic material to be used, and an autonomous thermoplastic material dispensing unit (5) which can be displaced, by means of a displacing system (24), in directions X, Y, Z to adjust the position of the material inlet in accordance with the cavity to be used.

## Claims

1. A method for manufacturing an embedded optics for photonic components, said photonic components being suitable for emitting or capturing an electromagnetic radiation of a given frequency, said optics being made of a thermoplastic material with a melting temperature Tₘ, said thermoplastic material being suitable for transmitting said electromagnetic radiation, said photonic component being on a physical carrier, **characterized in that** it is used a containment structure comprising a thermostatted cavity, suitable for being filled with said thermoplastic material, where said thermostatted cavity is open, and a support structure, suitable for supporting said physical carrier on said cavity such that said photonic component is inside said cavity, where when said physical carrier is supported by said support structure, said thermostatted cavity is partially open, where said method comprises the following steps:
[a] melting said thermoplastic material,
[b] positioning said physical carrier with said photonic component on said support structure, such that said photonic component is inside said thermostatted cavity and said thermostatted cavity being partially open,
[c] filling said thermostatted cavity with said molten thermoplastic material in a filling unit, where said thermostatted cavity is kept at a temperature T_{c} greater than Tₘ during the step of filling said thermostatted cavity by means of a temperature control system,
[d] once said thermostatted cavity is filled, cooling said thermostatted cavity below said Tₘ,
[e] ejecting said photonic component, coated with said thermoplastic material, from said thermostatted cavity by means of ejectors.

2. The method according to claim 1, **characterized in that** said filling unit is a controlled temperature and atmosphere gas unit, where said gas is preferably an oxygen-free gas.

3. The method according to claim 2, **characterized in that** said gas is at a temperature T_{g} greater than the temperature of said thermostatted cavity.

4. The method according to any one of claims 1 to 3, **characterized in that** said step [d] is performed in a cooling unit.

5. The method according to any one of claims 1 to 4, **characterized in that** said step [a] of melting said thermoplastic material is performed in an autonomous material dispensing unit which preferably has a temperature control system.

6. The method according to any one of claims 1 to 5, **characterized in that** said step [c] of filling said thermostatted cavity with said molten thermoplastic material is performed by gravity.

7. The method according to any one of claims 1 to 6, **characterized in that** said filling unit has an inlet area and an outlet area suitable for allowing the entry and exit, respectively, of said containment structure.

8. The method according to any one of claims 1 to 7, **characterized in that** said physical carrier comprises at least one hole and **in that** in said step [c] of filling said thermostatted cavity, said molten thermoplastic material exits said thermostatted cavity through said hole, forming a head suitable for retaining said optics on said physical carrier.

9. The method according to any one of claims 1 to 8, **characterized in that** said thermoplastic material is cyclic olefin polymer and **in that** said temperature T_{c} is comprised between 100°C and 420°C, preferably between 220°C and 260°C.

10. The method according to any one of claims 1 to 8, **characterized in that** said thermoplastic material is polycarbonate and **in that** said temperature T_{c} is comprised between 100°C and 420°C, preferably between 260°C and 310°C.

11. The method according to any one of claims 1 to 8, **characterized in that** said thermoplastic material is polymethylmethacrylate and **in that** said temperature T_{c} is comprised between 100°C and 420°C, preferably between 100°C and 180°C.

12. A containment structure **characterized in that** it comprises: [a] a thermostatted cavity, suitable for being filled with a molten thermoplastic material, where said thermostatted cavity is open, [b] a support structure, suitable for supporting a physical carrier with a photonic component on said thermostatted cavity such that said photonic component is inside said thermostatted cavity, where when said physical carrier is supported by said support structure, said thermostatted cavity is partially open, and [c] a temperature control system suitable for keeping said thermostatted cavity at a temperature T_{c} greater than the melting temperature Tₘ of said thermoplastic material.

13. The containment structure according to claim 12, **characterized in that** it comprises ejectors suitable for ejecting said photonic component, coated with said thermoplastic material, from said thermostatted cavity.

14. The containment structure according to one of claims 12 or 13, **characterized in that** it comprises a plurality of thermostatted cavities.

15. An autonomous thermoplastic material dispensing unit, **characterized in that** it comprises a temperature control system suitable for melting said plastic material and keeping it at a temperature T_{d} greater than Tₘ and **in that** it dispenses said molten thermoplastic material by gravity.

16. A device for manufacturing an embedded optics for photonic components, said photonic components being suitable for emitting or capturing an electromagnetic radiation of a given frequency, said optics being made of a thermoplastic material with a melting temperature Tₘ, said thermoplastic material being suitable for transmitting said electromagnetic radiation, said photonic component being on a physical carrier, **characterized in that** it comprises a containment structure and a filling unit where said containment structure, in turn, comprises: [a] a thermostatted cavity, suitable for being filled with a molten thermoplastic material, where said thermostatted cavity is open, [b] a support structure, suitable for supporting a physical carrier with a photonic component on said cavity such that said photonic component is inside said cavity, where when said physical carrier is supported by said support structure, said thermostatted cavity is partially open, and [c] a temperature control system suitable for keeping said thermostatted cavity at a temperature T_{c} greater than the melting temperature Tₘ of said thermoplastic material.

17. The device according to claim 16, **characterized in that** said containment structure comprises ejectors suitable for ejecting said photonic component, coated with said thermoplastic material, from said thermostatted cavity.

18. The device according to one of claims 16 or 17, **characterized in that** said containment structure comprises a plurality of thermostatted cavities.

19. The device according to any one of claims 16 to 18, **characterized in that** it comprises an autonomous thermoplastic material dispensing unit which, in turn, comprises a temperature control system suitable for melting said plastic material and keeping it at a temperature T_{d} greater than Tₘ and dispenses said molten thermoplastic material by gravity.

20. The device according to claim 19, **characterized in that** said autonomous thermoplastic material dispensing unit comprises a reservoir suitable for containing an oxygen-free gas.

21. The device according to any one of claims 16 to 20, **characterized in that** said filling unit is a controlled temperature and atmosphere gas unit, where said gas is preferably an oxygen-free gas.

22. The device according to claim 21, **characterized in that** said controlled temperature and atmosphere gas unit has a temperature control system suitable for keeping said gas at a temperature T_{g} greater than the temperature of said thermostatted cavity.

23. The device according to any one of claims 16 to 22, **characterized in that** said filling unit has an inlet area and an outlet area suitable for allowing the entry and exit, respectively, of said containment structure.

24. The device according to any one of claims 16 to 23, **characterized in that** it comprises a cooling unit.

25. The device according to claims 23 and 24, **characterized in that** said outlet area is connected to an inlet of said cooling unit.

26. The device according to any one of claims 16 to 25, **characterized in that** it comprises a heating plate that allows the temperature of said cavity to be adjusted.

27. The device according to any one of claims 16 to 26, **characterized in that** it is suitable for carrying out the method according to any one of claims 1 to 11.
